# EUROPEAN PATENT APPLICATION

(11) **EP 4 768 953 A1**
(43) Date of publication of application: **01.07.2026**
(21) Application number: 24880116.9
(22) Date of filing: 16.10.2024
(51) Int. Cl.: G01R 31/389, G01R 31/382, G01R 31/385, G01R 27/08, H02J 7/00

(54) **BATTERY MANAGEMENT DEVICE AND OPERATING METHOD THEREOF**

(30) Priority: 17.10.2023 KR 20230138529
(71) Applicant: LG Energy Solution, Ltd., Seoul 07335 (KR)
(72) Inventor: LI, Guang Ri, Daejeon 34122 (KR); LEE, Bom Jin, Daejeon 34122 (KR)
(74) Representative: Plasseraud IP
(86) International application number: PCT/KR2024/015695
(87) International publication number: WO 2025/084779

(57) **Abstract**

A battery management apparatus according to an embodiment disclosed in this document may include an information acquisition unit that acquires a voltage of each of a plurality of battery cells, and a controller that calculates a resistance of each of the plurality of battery cells corresponding to a SOC class including at least one SOC based on the voltage of each of the plurality of battery cells when the plurality of battery cells are charged based on a preset charging protocol and diagnoses each of the plurality of battery cells based on the resistance of each of the plurality of battery cells corresponding to the SOC class.

## Description

### TECHNICAL FIELD

### CROSS-REFERENCE TO RELATED APPLICATION

This application claims the priority of Korean Patent Application No. 10-2023-0138529 filed on October 17, 2023, in the Korean Intellectual Property Office, the disclosure of which is incorporated herein by reference.

### TECHNICAL FIELD

The present invention relates to a battery management apparatus and an operating method of the same.

### BACKGROUND ART

Recently, research and development on secondary batteries are being actively conducted. Here, the secondary batteries are batteries that can be charged and discharged, and refer to batteries that include both Ni/Cd batteries and Ni/MH batteries of the related art, and recent lithium-ion batteries. Among the secondary batteries, the lithium-ion batteries have an advantage of having a much higher energy density than the Ni/Cd batteries and Ni/MH batteries of the related art, etc. In addition, the lithium-ion batteries can be manufactured to be small and lightweight, and thus they are used as a power source for mobile devices. Recently, their range of use has expanded to a power source for electric vehicles, and they are attracting attention as a next-generation energy storage medium.

If lithium precipitation occurs in batteries, performance may decrease and there may be a risk of fire, and thus various technologies for diagnosing lithium precipitation in batteries are being devised. Among the technologies, there is a technology that uses open circuit voltage (OCV) for diagnosing lithium precipitation, but the technology that uses the OCV requires a long rest time due to the characteristics of OCV, and thus there is a disadvantage in that the time required for diagnosis increases. Therefore, in order to satisfy users who actually use batteries, a diagnostic charging protocol that has a similar required time to the normal charging time is required.

### DISCLOSURE

### TECHNICAL PROBLEM

An aspect of the present invention provides a battery management apparatus that can diagnose a plurality of battery cells during charging through a diagnostic charging protocol, and an operating method of the same.

Another aspect of the present invention provides a battery management apparatus that can calculate a resistance of each of a plurality of battery cells corresponding to a state of charge (SOC) and diagnose the plurality of battery cells based on the calculated resistance, and an operating method of the same.

The technical problems to be solved of the embodiments disclosed in this document are not limited to the technical problems to be solved mentioned above, and other technical problems to be solved not mentioned will be clearly understood by those skilled in the art from the description below.

### TECHNICAL SOLUTION

According to an aspect of the present invention, there is provided a battery management apparatus including an information acquisition unit that acquires a voltage of each of a plurality of battery cells, and a controller that calculates a resistance of each of the plurality of battery cells corresponding to a SOC class including at least one SOC based on the voltage of each of the plurality of battery cells when the plurality of battery cells are charged based on a preset charging protocol and diagnoses each of the plurality of battery cells based on the resistance of each of the plurality of battery cells corresponding to the SOC class.

In an embodiment, the controller may calculate a first average resistance of each of the plurality of battery cells which corresponds to an average of resistances corresponding to the SOC class for each of the plurality of battery cells, calculate a second average resistance corresponding to an average of the first average resistance of each of the plurality of battery cells, and diagnose each of the plurality of battery cells based on the first average resistance and the second average resistance of each of the plurality of battery cells.

In an embodiment, the controller may calculate a probability distribution of the first average resistance of each of the plurality of battery cells based on the first average resistance and the second average resistance of each of the plurality of battery cells, and diagnose each of the plurality of battery cells based on the probability distribution.

In an embodiment, the controller may calculate a standard deviation of the first average resistance of each of the plurality of battery cells based on the second average resistance, and diagnose that lithium precipitation has occurred in a battery cell having the first average resistance that differs from the second average resistance by a set deviation or more.

In an embodiment, the charging protocol may be configured to repeat a charging method of charging as much as a first SOC at a first C-rate and resting for a first time.

In an embodiment, the controller may calculate the resistance of each of the plurality of battery cells while charging the plurality of battery cells at the first C-rate.

In an embodiment, the controller may calculate an amount of change in voltage of each of the plurality of battery cells for a second time when charging the plurality of battery cells at the first C-rate, and calculate the resistance of each of the plurality of battery cells by dividing the change in voltage of each of the plurality of battery cells by a charging current.

In an embodiment, the charging protocol may be configured to repeat a charging method of charging as much as a first SOC at a first C-rate and charging for a time set at a second C-rate, and the second C-rate may be smaller than the first C-rate.

In an embodiment, the controller may calculate the resistance of each of the plurality of battery cells while charging the plurality of battery cells at the first C-rate.

According to another aspect of the present invention, there is provided an operating method of a battery management apparatus, the method including an operation of acquiring a voltage of each of a plurality of battery cells, an operation of calculating a resistance of each of the plurality of battery cells corresponding to a SOC class including at least one SOC based on the voltage of each of the plurality of battery cells when the plurality of battery cells are charged based on a preset charging protocol, and an operation of diagnosing each of the plurality of battery cells based on the resistance of each of the plurality of battery cells corresponding to the SOC class.

In an embodiment, the operation of diagnosing each of the plurality of battery cells based on the resistance of each of the plurality of battery cells corresponding to the SOC class may include an operation of calculating a first average resistance of each of the plurality of battery cells which corresponds to an average of resistances corresponding to the SOC class for each of the plurality of battery cells, and an operation of calculating a second average resistance corresponding to an average of the first average resistance of each of the plurality of battery cells.

In an embodiment, the operation of diagnosing each of the plurality of battery cells based on the resistance of each of the plurality of battery cells corresponding to the SOC class may further include an operation of calculating a probability distribution of the first average resistance of each of the plurality of battery cells based on the first average resistance and the second average resistance of each of the plurality of battery cells, and an operation of diagnosing each of the plurality of battery cells based on the probability distribution.

In an embodiment, the operation of diagnosing each of the plurality of battery cells based on the resistance of each of the plurality of battery cells corresponding to the SOC class may further include an operation of calculating a standard deviation of the first average resistance of each of the plurality of battery cells based on the second average resistance, and an operation of diagnosing that lithium precipitation has occurred in a battery cell having the first average resistance that differs from the second average resistance by a set deviation or more.

In an embodiment, the charging protocol may be configured to repeat a charging method of charging as much as a first SOC at a first C-rate and resting for a first time.

In an embodiment, in the operation of calculating a resistance of each of the plurality of battery cells corresponding to a SOC class including at least one SOC based on the voltage of each of the plurality of battery cells when the plurality of battery cells are charged based on a preset charging protocol, the resistance of each of the plurality of battery cells may be calculated while charging the plurality of battery cells at the first C-rate.

In an embodiment, the operation of calculating a resistance of each of the plurality of battery cells corresponding to a SOC class including at least one SOC based on the voltage of each of the plurality of battery cells when the plurality of battery cells are charged based on a preset charging protocol may include an operation of calculating an amount of change in voltage of each of the plurality of battery cells for a second time when charging the plurality of battery cells at the first C-rate, and an operation of calculating the resistance of each of the plurality of battery cells by dividing the change in voltage of each of the plurality of battery cells by a charging current.

In an embodiment, the charging protocol may be configured to repeat a charging method of charging as much as a first SOC at a first C-rate and charging for a time set at a second C-rate, and the second C-rate may be smaller than the first C-rate.

In an embodiment, in the operation of calculating a resistance of each of the plurality of battery cells corresponding to a SOC class including at least one SOC based on the voltage of each of the plurality of battery cells when the plurality of battery cells are charged based on a preset charging protocol, the resistance of each of the plurality of battery cells may be calculated while charging the plurality of battery cells at the first C-rate.

### ADVANTAGEOUS EFFECTS

The battery management apparatus and operating method of the same according to an aspect of the present invention can diagnose a plurality of battery cells during charging through a diagnostic charging protocol.

The battery management apparatus and operating method of the same according to the aspect of the present invention can calculate the resistance of each of the plurality of battery cells corresponding to a SOC class including at least one SOC based on the voltage of each of the plurality of battery cells when charging based on a diagnostic charging protocol, and diagnose each of the plurality of battery cells based on the calculated resistance.

The battery management apparatus and operating method of the same according to the aspect of the present invention can calculate a probability distribution of resistance of each of a plurality of battery cells corresponding to a SOC class, and diagnose each of the plurality of battery cells based on the calculated probability distribution.

The battery management apparatus and operating method of the same according to the aspect of the present invention can diagnose each of the plurality of battery cells while efficiently charging the plurality of battery cells through various diagnostic charging protocols.

In addition, various effects that can be directly or indirectly grasped through the aspects of the present invention may be provided.

### DESCRIPTION OF DRAWINGS

FIG. 1 is a block diagram showing a configuration of a general battery pack.
FIG. 2 is a block diagram showing a battery management apparatus according to an embodiment disclosed in this document.
FIG. 3 is a diagram showing an example of a charging protocol according to an embodiment disclosed in this document.
FIGS. 4 and 5 are diagrams showing an example in which a plurality of battery cells are diagnosed by the battery management apparatus according to an embodiment disclosed in this document.
FIG. 6 is a flowchart showing an operating method of the battery management apparatus according to an embodiment disclosed in this document.
FIGS. 7 to 10 are flowcharts specifically showing the operating method of the battery management apparatus According to an embodiment disclosed in this document.
FIG. 11 is a block diagram showing a hardware configuration of a computing system for performing the operating method of the battery management apparatus according to an embodiment disclosed in this document.

### MODE FOR INVENTION

Hereinafter, embodiments disclosed in this document will be described in detail through exemplary drawings. When adding reference numerals to components in each drawing, it should be noted that the same components are given the same reference numerals as much as possible even if they are shown in different drawings. In addition, in describing the embodiments disclosed in this document, if it is determined that detailed descriptions of related known configurations or functions impede understanding of the embodiments disclosed in this document, the detailed descriptions thereof will be omitted.

In describing the components of the embodiment disclosed in this document, terms such as first, second, A, B, (a), (b), etc. may be used. These terms are only used to distinguish the component from other components, and the nature, sequence, or order of the component is not limited by the terms. In addition, unless otherwise defined, all terms used herein, including technical or scientific terms, have the same meaning as commonly understood by a person of ordinary skill in the technical field to which the embodiments disclosed in this document pertain. Terms that are defined in commonly used dictionaries are such as those defined in the dictionary should be interpreted as having a meaning consistent with the meaning in the context of the related technology, and unless clearly defined in this application, should not be interpreted in an ideal or excessively formal sense.

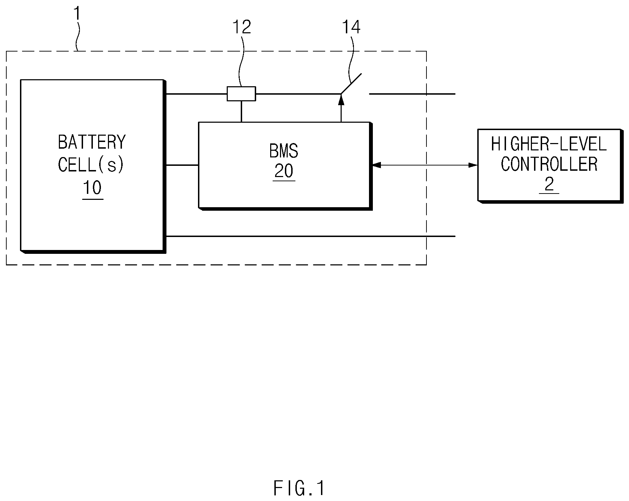

FIG. 1 is a block diagram showing a configuration of a general battery pack.

Referring to FIG. 1, a battery control system including a battery pack 1 and a higher-level controller 2 included in a higher-level system according to an embodiment of the present invention is schematically shown.

As shown in FIG. 1, the battery pack 1 includes a plurality of battery cells 10 composed of one or more battery cells and capable of being charged and discharged, a switching unit 14 connected in series to a positive terminal side or a negative terminal side of the plurality of battery cells 10 to control the flow of charge and discharge current of the plurality of battery cells 10, and a battery management system 20 that monitors the voltage, current, and temperature of the battery pack 1 and controls it to prevent overcharging and overdischarging. In this case., the battery pack 1 may be provided with a plurality of battery cells 10, a plurality of sensors 12, a plurality of switching units 14, and a plurality of battery management system 20.

Here, the switching unit 14 is an element for controlling the current flow for charging or discharging of the plurality of battery cells 10. For example, as the switching unit 14, at least one relay, magnetic contactor, etc. may be used depending on the specifications of the battery pack 1.

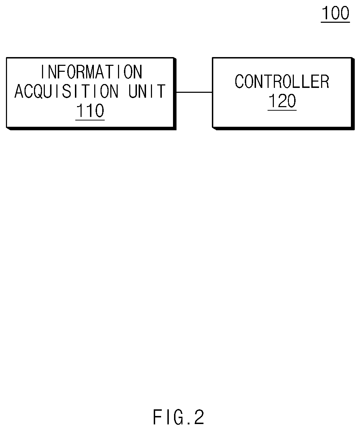

The battery management system 20 is an interface that receives measured values of various parameters described above as input, and may include a plurality of terminals, a circuit connected to these terminals to process the received values, etc. In addition, the battery management system 20 may control ON/OFF of the switching unit 14, for example, a relay or a contactor, and may be connected to the plurality of battery cells 10 to monitor a state of each of the plurality of battery cells 10. According to an embodiment, the battery management system 20 may include a battery management apparatus 100 of FIG. 2. According to another embodiment, the battery management system 20 may be a different system from the battery management apparatus 100 of FIG. 2. That is, the battery management apparatus 100 of FIG. 2 may be included in the battery pack 1 or may be configured as another apparatus external to the battery pack 1. In addition, an operation of the battery management apparatus 100 below may be performed by a battery management system (BMS) in a vehicle, as well as by various apparatuses such as a server, cloud, charger, or charger/discharger.

The higher-level controller 2 may transmit a control signal for the plurality of battery cells 10 to the battery management system 20. Accordingly, the operation of the battery management system 20 may be controlled based on the signal applied from the higher-level controller 2.

FIG. 2 is a block diagram showing a battery management apparatus according to an embodiment disclosed in this document.

The battery management apparatus 100 may be a variety of electronic apparatuses for managing, diagnosing, and testing the batteries. According to an embodiment, the battery management apparatus 100 may be included in any one of the battery management system (BMS) inside the battery pack, a battery management server, a computer, and a cloud server. According to another embodiment, the battery management apparatus 100 may be included in an apparatus for charge/discharge testing, such as a charge/discharge cycler.

During charging of the plurality of battery cells 10, the BMS 20, the battery charging protocol, the controller 120, or other component of the battery pack 1 or battery management apparatus 100 described herein may identify or group the battery cells 10 to be included in one or more SOC classes. In some embodiments, each SOC class may include a grouping of battery cells 10 having a particular state of charge (SOC) value or falling within a range of SOC values.

Each SOC class can include any SOC value and/or any range of SOC values. In one example, a SOC class can include all battery cells 10 having a particular SOC value, such as all battery cells having a 5% SOC or 10% SOC. In another example, a SOC class may comprise all battery cells 10 falling within a particular range of SOC values (e.g., having a SOC of 10%-20, 20%-30%, 30%-40%, etc.). In other examples, a SOC class may include all battery cells 10 having SOCs values ranging from 1% to 100% or 0% to 100%.

Referring to FIG. 2, the battery management apparatus 100 according to an embodiment disclosed in this document may include an information acquisition unit 110 and a controller 120.

The information acquisition unit 110 may acquire a voltage of each of the plurality of battery cells. For example, the information acquisition unit 110 may acquire the voltage of each of the plurality of battery cells in time series. For another example, the information acquisition unit 110 may acquire the voltage of each of the plurality of battery cells that are being charged.

The structure or arrangement of the information acquisition unit 110 can vary based on a configuration of the battery management apparatus 100. In some examples, the battery management apparatus 100 can be directly integrated into a BMS, battery pack 1, or a device that includes the battery pack 1. In this scenario, the information acquisition unit 110 may correspond to one or more voltage measurement sensors that are configured to measure the voltage of the plurality of battery cells.

In other examples, the battery management apparatus 100 (or certain components of the battery management apparatus 100) may be incorporated into a remote monitoring system (e.g., a cloud-based remote monitoring server or computing system) that is in communication with the battery pack 1 or device including the battery pack 1. In this scenario, the information acquisition unit 110 may correspond to a processor, a transceiver, and/or a memory storage device (e.g., a memory storage device that stores computing instructions for performing the functions of the information acquisition unit 110) that receives the voltage measurements for the plurality of battery cells. Other configurations of the information acquisition unit 110 also are possible.

The controller 120 may calculate a resistance of each of the plurality of battery cells based on a voltage of each of the plurality of battery cells. For example, when a plurality of battery cells are charged based on a preset charging protocol, the controller 120 may calculate the resistance of each of the plurality of battery cells based on the voltage of each of the plurality of battery cells.

According to an embodiment, the controller 120 may calculate the resistance of each of a plurality of battery cells corresponding to a SOC class including at least one SOC. For example, the SOC class may include a single SOC or a plurality of SOCs. For another example, the SOC class may include all 100 SOCs from SOC 1 to SOC 100, but is not limited thereto, and may include at least one SOC from SOC 0 to SOC 100. According to an embodiment, when the plurality of battery cells are charged, the controller 120 may calculate the resistance of each of the plurality of battery cells based on the voltage of each of the plurality of battery cells when the plurality of battery cells reach the SOC included in the SOC class.

According to an embodiment, a charging protocol may be configured to repeat a charging method of charging as much as a first SOC at a first C-rate and resting for a first time. For example, the first SOC may be a SOC included in the SOC class. For another example, when the SOC class includes a total of 100 SOCs from SOC 1, SOC 2, SOC 3 to SOC 100, the charging protocol may be configured to repeat the charging method of charging as much as one SOC at the first C-rate and resting for 30 seconds. According to an embodiment, the first C-rate may be 0.3 C, and the first time may be 30 seconds, but are not limited thereto.

In this case, the controller 120 may calculate the resistance of each of the plurality of battery cells while charging the plurality of battery cells at the first C-rate. For example, when charging the plurality of battery cells at the first C-rate, the controller 120 may calculate an amount of change in voltage of each of the plurality of battery cells for a second time. In addition, the controller 120 may calculate the resistance of each of the plurality of battery cells by dividing the change in voltage of each of the plurality of battery cells by a charging current. According to an embodiment, the second time may be one second, but is not limited thereto, and the controller 120 may calculate the resistance of each battery cell based on an amount of change in voltage between a voltage at the time of starting charging at the first C-rate and a voltage after the second time.

According to another embodiment, the charging protocol may be configured to repeat the charging method of charging as much as the first SOC at the first C-rate and charging for a set time at a second C-rate, and the second C-rate may be smaller than the first C-rate. For example, the first SOC may be a SOC included in the SOC class. That is, the battery management apparatus 100 according to embodiments disclosed in this document may diagnose each of the plurality of battery cells while the plurality of battery cells are being charged, based on various charging protocols.

In this case, the controller 120 may calculate the resistance of each of the plurality of battery cells while charging the plurality of battery cells at the first C-rate. For example, when charging the plurality of battery cells at the first C-rate, the controller 120 may calculate the amount of change in voltage of each of the plurality of battery cells for the second time. In addition, the controller 120 may calculate the resistance of each of the plurality of battery cells by dividing the change in voltage of each of the plurality of battery cells by the charging current. According to an embodiment, the second time may be one second, but is not limited thereto, and the controller 120 may calculate the resistance of each battery cell based on the amount of change in voltage between a voltage at the time of starting charging at the first C-rate and the voltage after the second time.

According to an embodiment, the charging protocol may include a variety of charging methods that repeat a plurality of C-rates and resting and repeat charging up to the SOC included in the SOC class.

The controller 120 may diagnose each of the plurality of battery cells based on the resistance of each of the plurality of battery cells corresponding to the SOC class. For example, the controller 120 may calculate a first average resistance of each of the plurality of battery cells corresponding to an average of resistances of each of the plurality of battery cells corresponding to the SOC class, and calculate a second average resistance corresponding to an average of the first average resistance of each of the plurality of battery cells. In this case, the controller 120 may diagnose each of the plurality of battery cells based on the first average resistance and the second average resistance of each of the plurality of battery cells.

That is, by diagnosing each of the plurality of battery cells through the first average resistance corresponding to the average of the resistances of each of the plurality of battery cells corresponding to the SOC class, the controller 120 can prevent the occurrence of misdiagnosis due to an error when diagnosing by measuring the voltage at a single SOC. However, when an accuracy of resistance measurement is high, the controller 120 may diagnose each of the plurality of battery cells based on the resistance of the plurality of battery cells corresponding to a single SOC.

Table 1 below illustrates details of an exemplary technique for determining first average resistance values and second average resistance values according to certain embodiments.

**[Table 1]**

| Battery Cells | SOC 1% | SOC 2% | ... | SOC 100% | 1st Average Resistance |
|---|---|---|---|---|---|
| Cell-1 | R1SOC1 | R1SOC2 | ... | R1SOC100 | R1avg |
| Cell-2 | R2SOC1 | R2SOC2 | ... | R2SOC100 | R2avg |
| ... | ... | ... | ... | ... | ... |
| Cell-N | RNSOC1 | RNSOC2 | ... | RNSOC100 | RNavg |
| | | | | | |
| 2nd Avg. Rest. | | | | | SecondAvgRest |

According to an embodiment, a charging protocol is applied to a plurality of battery cells included in a SOC class (such as battery cells Cell-1, Cell-2... Cell-N, where N can be any positive integer value). A resistance value for each battery cell is calculated multiple times as the battery cell is being charged and reaches different SOC values (e.g., SOC %1, SOC 2%, through SOC 100%).

For example, a first resistance value (R1SOC1, R2SOC1...RNSOC1) is calculated for each of the battery cells (Cell-1, Cell-2...Cell-N) at a first point in time when the battery cells have a first SOC value (SOC 1%), a second resistance value (R1SOC2, R2SOC2...RNSOC2) is calculated for each of the battery cells at a second point in time when the battery cells have a second SOC value (SOC 2%), etc.

In some embodiments, the resistance value for each of the battery cells may be continuously determined or calculated until each of the battery cells is fully charged (e.g., at S0C 100%) and/or up to a predetermined SOC threshold (e.g., at S0C 10%, S0C 50%, etc.).

A first average resistance value is calculated for each of the battery cells based on the resistance values measured or calculated for a corresponding battery cell over time. For example, the first average resistance (R1avg) for Cell-1 may be computed by averaging the resistance values (R1SOC1, R1SOC2...R1SOC100) calculated for the Cell-1 at different SOC levels and/or at different points in time. The first average resistance values for the other cells (e.g., Cell-2 through Cell-N) may be calculated in the same fashion.

In some embodiments, the first average resistance values for the battery cells can be continuously updated over time as new resistance values are determined over time. For example, the first average resistance value for the battery cell can be recomputed or updated each time a resistance value is computed for a given battery cell. At any point in time during the charging of the battery cell, the first average resistance value for the given battery cell may reflect the average of all resistance values derived for the battery cell.

A second average resistance (SecondAvgRest) can be calculated by computing the average of the first average resistance values. For example, the second average resistance may be determined by averaging the first average resistance values (R1avg, R2avg,...RNavg) for Cell-1 through Cell-N. In some examples, the second average resistance can be continuously recalculated over time (e.g., each time a new set of resistance values is computed for a new SOC level).

The exemplary technique for computing the first and second average resistance values illustrated in Table 1 can be varied in many ways. Amongst other things, these resistance calculations can be performed for any number of battery cells, and any number of resistance values can be measured or calculated for each of the battery cells (e.g., in some cases, at least two or more resistance values are calculated for each battery cell).

Additionally, while Table 1 provides an example in which the resistance values are determined for each battery cell at one percent SOC value intervals, the resistance values can be measured or calculated at any desired interval (e.g., at .1% intervals, .5% intervals, 2% intervals, 5% intervals, etc.). Additionally, the resistance values for each battery does not need to be continuously calculated up to a SOC level of 100% and can be computed up to any desired SOC level or threshold.

According to an embodiment, the controller 120 may calculate the first average resistance by removing noise from the resistance of each of the plurality of battery cells corresponding to the SOC class. For example, the controller 120 may calculate the first average resistance by excluding the maximum value and minimum value from the resistances of each of the plurality of battery cells corresponding to the SOC class. For another example, the controller 120 may calculate a regression equation for the resistance of each of the plurality of battery cells based on the resistance of each of the plurality of battery cells corresponding to the SOC class, and may diagnose each of the plurality of battery cells based on the regression equation.

According to an embodiment, the controller 120 may calculate a probability distribution of the first average resistance of each of the plurality of battery cells based on the first average resistance and the second average resistance of each of the plurality of battery cells, and diagnose each of a plurality of battery cells based on the probability distribution. For example, the controller 120 may diagnose a battery cell having the first average resistance that differs from the second average resistance by a set value or more in the probability distribution as an abnormal battery cell. For another example, the controller 120 may diagnose the battery cell having the first average resistance that differs from the second average resistance by a set value or more in the probability distribution as a battery cell in which lithium precipitation has occurred. Additionally, the controller 120 may also diagnose dendrite growth, short circuit, and thermal runaway in addition to lithium deposition.

According to an embodiment, the controller 120 may calculate a standard deviation of the first average resistance of each of the plurality of battery cells based on the second average resistance. In this case, the controller 120 may diagnose that lithium precipitation has occurred in the battery cell having the first average resistance that differs from the second average resistance by a set deviation or more. For example, the set deviation may be 2 sigma.

Therefore, the battery management apparatus 100 according to an embodiment disclosed in this document can diagnose the plurality of battery cells during charging through a diagnostic charging protocol.

In addition, the battery management apparatus 100 according to an embodiment disclosed in this document may calculate the resistance of each of the plurality of battery cells corresponding to the SOC class including at least one SOC based on the voltage of each of the plurality of battery cells when charging based on the diagnostic charging protocol, and diagnose each of the plurality of battery cells based on the calculated resistance.

In addition, the battery management apparatus 100 according to an embodiment disclosed in this document may calculate the probability distribution of resistance of each of the plurality of battery cells corresponding to the SOC class and diagnose each of the plurality of battery cells based on the calculated probability distribution.

In addition, the battery management apparatus 100 according to an embodiment disclosed in this document may diagnose each of the plurality of battery cells while efficiently charging the plurality of battery cells through various diagnostic charging protocols.

In addition, the battery management apparatus 100 according to an embodiment disclosed in this document may prevent the misdiagnosis due to an measurement error by diagnosing each of the plurality of battery cells based on the average of the resistances of each of the plurality of battery cells measured at various SOCs.

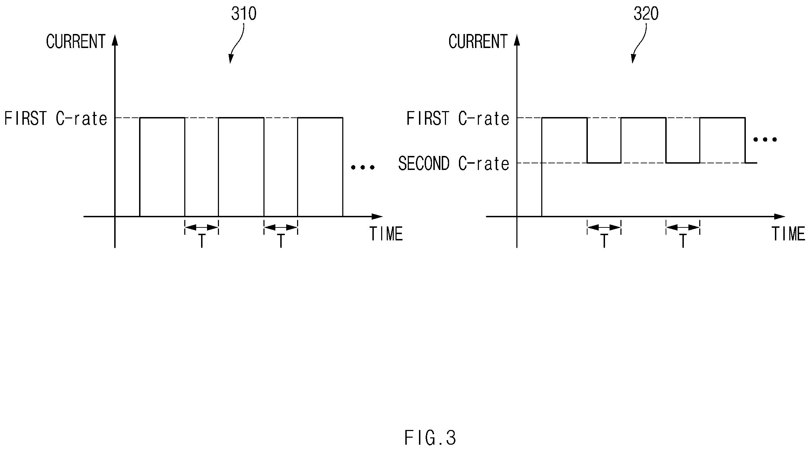

FIG. 3 is a diagram showing an example of a charging protocol according to an embodiment disclosed in this document.

Referring to FIG. 3, a first charging protocol 310 may be configured to repeat the charging method of charging as much as the first SOC at the first C-rate and resting for a first time T.

A second charging protocol 320 may be configured to repeat the charging method of charging as much as the first SOC at the first C-rate and charging at the second C-rate for a second time T.

Therefore, the battery management apparatus 100 can diagnose the plurality of battery cells while charging them according to each charging protocol. By diagnosing multiple battery cells during charging, the battery management apparatus 100 can optimize the time for diagnosing a plurality of battery cells and inform a user of a diagnosis result after charging is complete.

In some embodiments, a real-time diagnosis result may be provided during the charging process, which can immediately indicate if an abnormal battery condition (e.g., a lithium precipitation condition) is detected during the charging process. For example, when the battery management apparatus 100 has acquired sufficient information to diagnose an abnormal battery condition before the charging process as completed and/or before the battery cells have reached a SOC value of 100%, the diagnosis result can be output prior to the completion of the charging process.

In addition to the charging protocol shown in FIG. 3, the charging protocol may be configured to repeat an operation of charging at various C-rates and then resting or charging at a low C-rate. According to an embodiment, the charging protocol may be configured to repeat the first C-rate, the second C-rate, and resting.

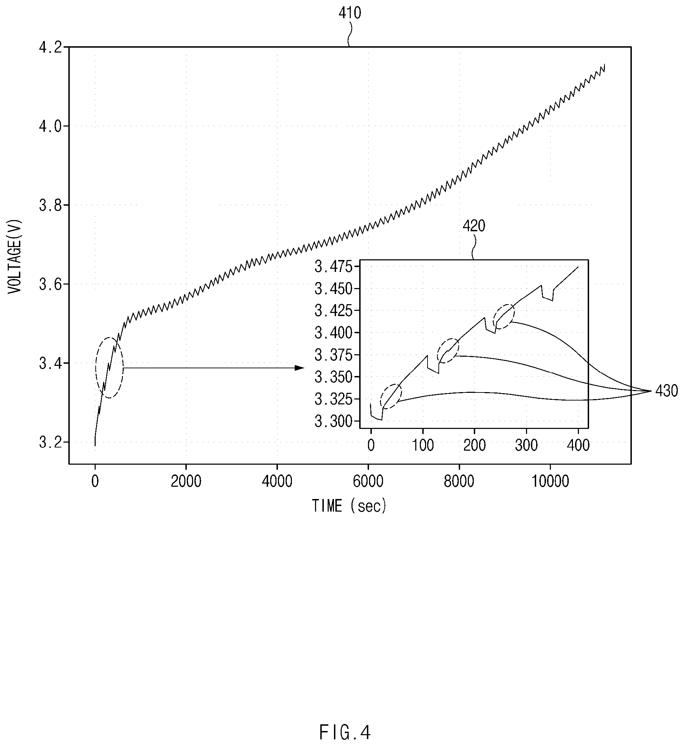

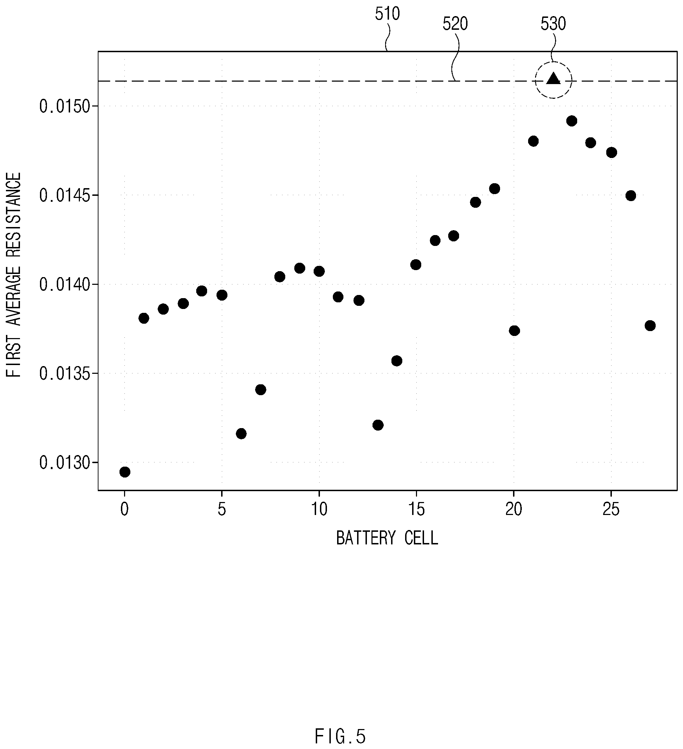

FIGS. 4 and 5 are diagrams showing an example of the battery management apparatus diagnosing a plurality of battery cells according to an embodiment disclosed in this document.

Referring to FIG. 4, the information acquisition unit 110 may acquire voltages 410 of the plurality of battery cells. Although only the voltage of a single battery cell is shown in FIG. 4, the information acquisition unit 110 may acquire the voltages 410 of the plurality of battery cells.

When the plurality of battery cells are charged based on a preset charging protocol, the controller 120 may calculate the voltage of each of the plurality of battery cells corresponding to the SOC class including at least one SOC based on the voltage 410 of each of the plurality of battery cells.

Referring to some voltages 420 of the voltages 410 of the plurality of battery cells in FIG. 4, the controller 120 may calculate the resistance of each of the plurality of battery cells while charging the plurality of battery cells at a first C-rate 430. According to an embodiment, when charging the plurality of battery cells at the first C-rate, the controller 120 may calculate the amount of change in voltage of each of the plurality of battery cells for the second time, and calculate the resistance of each of the plurality of battery cells by dividing the change in voltage of each of the plurality of battery cells by a charging current. For example, while charging 430 the plurality of battery cells at the first C-rate, the controller 120 may calculate the resistance based on the change in voltage between one second and second seconds after starting charging at the first C-rate, and calculate the resistance based on the amount of change in voltage between zero seconds and one second. That is, the controller 120 may calculate the resistance of each of the plurality of battery cells to correspond to various second times.

The controller 120 may diagnose each of the plurality of battery cells based on the resistance of each of the plurality of battery cells corresponding to the SOC class. For example, the controller 120 may calculate the first average resistance of each of the plurality of battery cells corresponding to the average of resistances of each of the plurality of battery cells corresponding to the SOC class, and calculate the second average resistance corresponding to the average of the first average resistance of each of the plurality of battery cells. In this case, the controller 120 may diagnose each of the plurality of battery cells based on the first average resistance and the second average resistance of each of the plurality of battery cells.

Referring to FIG. 5, the controller 120 may calculate a standard deviation 510 of the first average resistance of each of the plurality of battery cells based on the first average resistance and the second average resistance. In addition, the controller 120 may diagnose each of the plurality of battery cells based on a standard deviation 510 the first average resistance.

According to an embodiment, the controller 120 may diagnose that lithium precipitation has occurred in the battery cell 530 having the first average resistance that differs from the second average resistance by a set deviation 520 or more.

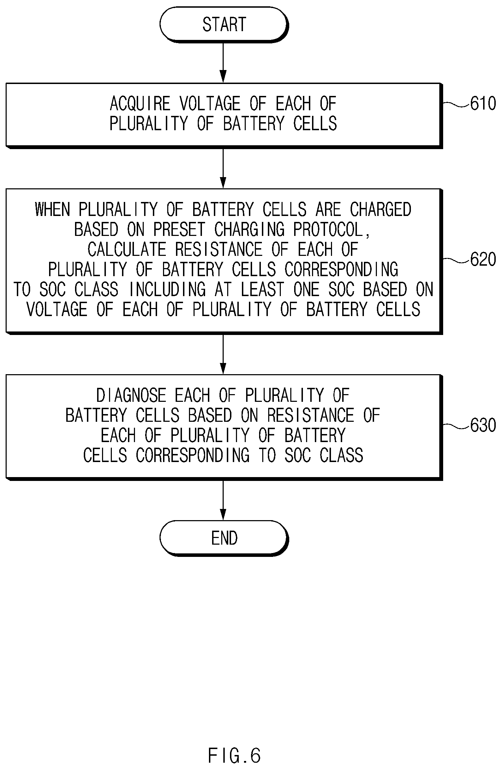

FIG. 6 is a flowchart showing an operating method of the battery management apparatus according to an embodiment disclosed in this document. According to an embodiment, the operations shown in FIG. 6 may be performed through the battery management apparatus 100 of FIG. 2.

Referring to FIG. 6, in operation 610, the information acquisition unit 110 may acquire the voltage of each of the plurality of battery cells. For example, the information acquisition unit 110 may acquire the voltage of each of the plurality of battery cells in time series. For another example, the information acquisition unit 110 may acquire the voltage of each of the plurality of battery cells that are being charged.

In operation 620, when the plurality of battery cells are charged based on a preset charging protocol, the controller 120 may calculate the resistance of each of the plurality of battery cells corresponding to the SOC class including at least one SOC based on the voltage of each of the plurality of battery cells. For example, the SOC class may include a single SOC or a plurality of SOCs. For another example, the SOC class may include all 100 SOCs from SOC 1 to SOC 100, but is not limited thereto, and may include at least one SOC from SOC 0 to SOC 100. According to an embodiment, when the plurality of battery cells are charged the controller 120 may calculate the resistance of each of the plurality of battery cells based on the voltage of each of the plurality of battery cells when the plurality of battery cells reach the SOC included in the SOC class.

According to an embodiment, the charging protocol may be configured to repeat a charging method of charging as much as the first SOC at the first C-rate and resting for the first time. In this case, the controller 120 may calculate the resistance of each of the plurality of battery cells while charging the plurality of battery cells at the first C-rate.

According to another embodiment, the charging protocol may be configured to repeat the charging method of charging as much as the first SOC at the first C-rate and charging for a set time at the second C-rate, and the second C-rate may be smaller than the first C-rate. In this case, the controller 120 may calculate the resistance of each of the plurality of battery cells while charging the plurality of battery cells at the first C-rate.

In operation 630, the controller 120 may diagnose each of the plurality of battery cells based on the resistance of each of the plurality of battery cells corresponding to the SOC class. For example, the controller 120 may diagnose each of the plurality of battery cells by calculating an average of resistances of each of the plurality of battery cells corresponding to the SOC class. According to an embodiment, the controller 120 may diagnose each of the plurality of battery cells by comparing the resistance of each of the plurality of battery cells with that of other battery cells.

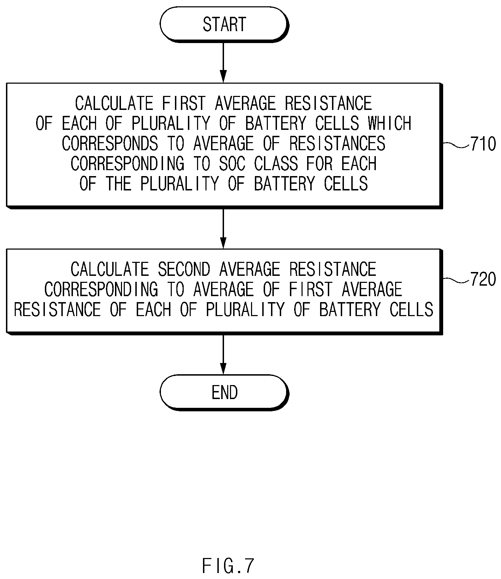

FIGS. 7 to 10 are flowcharts specifically showing the operating method of the battery management apparatus according to an embodiment disclosed in this document. According to an embodiment, operations shown in FIGS. 7 to 10 may be performed through the battery management apparatus 100 of FIG. 2.

Referring to FIG. 7, in operation 710, the controller 120 may calculate the first average resistance of each of the plurality of battery cells which corresponds to the average of the resistances corresponding to the SOC class, for each of the plurality of battery cells.

In operation 720, the controller 120 may calculate the second average resistance corresponding to the average of the first average resistance of each of the plurality of battery cells. In this case, the controller 120 may diagnose each of the plurality of battery cells based on the first average resistance and the second average resistance of each of the plurality of battery cells.

That is, by diagnosing each of the plurality of battery cells through the first average resistance which corresponds to the average of the resistances of each of the plurality of battery cells corresponding to the SOC class, the controller 120 can prevent the occurrence of misdiagnosis due to an error when diagnosing by measuring the voltage at a single SOC. However, when the accuracy of resistance measurement is high, the controller 120 may diagnose each of the plurality of battery cells based on the resistance of the plurality of battery cells corresponding to a single SOC.

According to an embodiment, operations 710 and 720 may be performed by being included in operation 630 of FIG. 6.

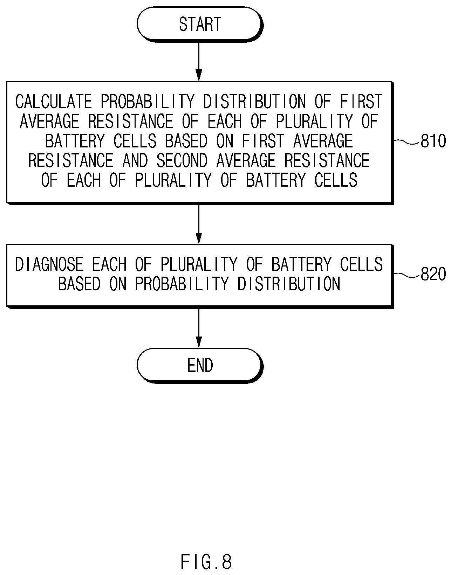

Referring to FIG. 8, in operation 810, the controller 120 may calculate a probability distribution of the first average resistance of each of the plurality of battery cells based on the first average resistance and the second average resistance of each of the plurality of battery cells.

In operation 820, the controller 120 may diagnose each of the plurality of battery cells based on the probability distribution. For example, the controller 120 may diagnose a battery cell having the first average resistance that differs from the second average resistance by a set value or more in the probability distribution as an abnormal battery cell. For another example, the controller 120 may diagnose the battery cell having the first average resistance that differs from the second average resistance by a set value or more in the probability distribution as a battery cell in which lithium precipitation has occurred.

According to an embodiment, operations 810 and 820 may be performed by being included in operation 630 of FIG. 6.

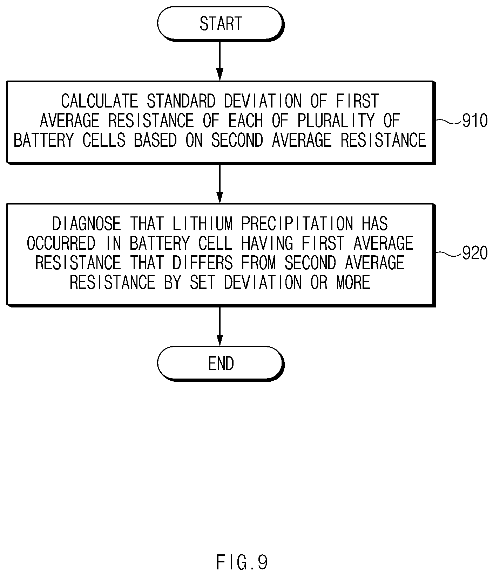

Referring to FIG. 9, in operation 910, the controller 120 may calculate the standard deviation of the first average resistance of each of the plurality of battery cells based on the second average resistance.

In operation 920, the controller 120 may diagnose that the lithium precipitation has occurred in the battery cell having the first average resistance that differs from the second average resistance by a set deviation or more. For example, the set deviation may be 2 sigma. According to an embodiment, operations 910 and 920 may be performed by being included in operation 630 of FIG. 6.

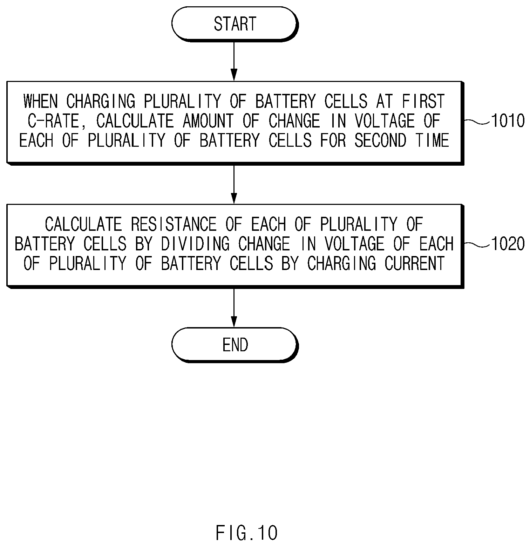

Referring to FIG. 10, in operation 1010, when charging the plurality of battery cells at the first C-rate, the controller 120 may calculate the amount of change in voltage of each of the plurality of battery cells for the second time. According to an embodiment, the second time may be one second, but is not limited thereto, and the controller 120 may calculate the resistance of each battery cell based on the amount of change in voltage between a voltage at the time of starting charging at the first C-rate and a voltage after the second time.

In operation 1020, the controller 120 may calculate the resistance of each of the plurality of battery cells by dividing the change in voltage of each of the plurality of battery cells by the charging current.

Operation 1010 and operation 1020 may be performed by being included in operation 620 of FIG. 6.

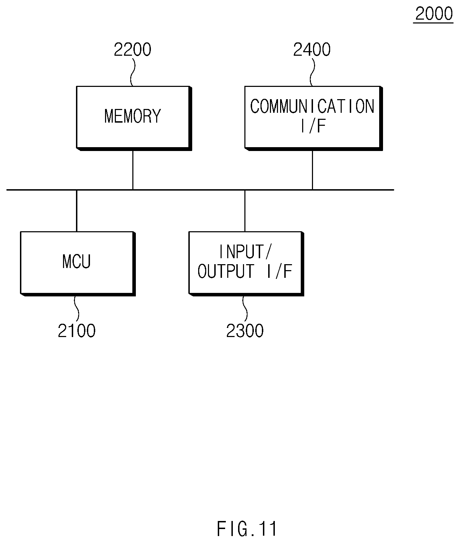

FIG. 11 is a block diagram showing a hardware configuration of a computing system for performing the operating method of the battery management apparatus according to an embodiment disclosed in this document.

Referring to FIG. 11, a computing system 2000 according to an embodiment disclosed in this document may include an MCU 2100, a memory 2200, an input/output I/F 2300, and a communication I/F 2400.

The MCU 2100 may be a processor adapted to cause various programs (e.g., a charging protocol execution program, a battery cell resistance calculation program, a battery cell diagnosis program, etc.) stored in the memory 2200 to be executed, process various information including the resistance of each of the plurality of battery cells, the average resistance thereof, the diagnosis result of each of the plurality of battery cells, etc. through these programs, and perform functions of the controller included in the battery management apparatus shown in FIG. 2 described above.

The memory 2200 may store various programs such as the charging protocol execution program, the battery cell resistance calculation program, the battery cell diagnosis program, etc. In addition, the memory 2200 may store various information, including the resistance of each of the plurality of battery cells, the average resistance thereof, the diagnosis result of each of the plurality of battery cells, etc.

A plurality of such memories 2200 may be provided as needed. The memory 2200 may be a volatile memory or a non-volatile memory. The memory 2200 as the volatile memory may be a RAM, a DRAM, an SRAM, etc. The memory 2200 as the non-volatile memory may be a ROM, a PROM, an EAROM, an EPROM, an EEPROM, a flash memory, etc. The examples of memories 2200 listed above are merely examples and are not limited to these examples.

The input/output I/F 2300 may provide an interface that allows data to be transmitted and received by connecting the MCU 2100 with input devices such as a keyboard, a mouse, and a touch panel (not shown) and an output device such as a display (not shown).

The communication I/F 2400 is a configuration that can transmit and receive various data with a server, and may be various devices that can support communication wirelessly or in a wired manner. For example, through the communication I/F 2400, the battery management apparatus can transmit and receive various information, including the resistance of each of the plurality of battery cells, the average resistance thereof, the diagnosis result of each of the plurality of battery cells, etc. from a separately provided external server.

In this way, the computer program according to an embodiment disclosed in this document may be recorded in the memory 2200 and processed by the MCU 2100, thereby capable of being implemented as a module that performs each function shown in FIG. 2, for example.

The description as above is merely an exemplary description of the technical ideas disclosed in this document. Those of ordinary skill in the technical field to which the embodiments disclosed in this document pertain will be able to make various modifications and variations thereto without departing from the essential characteristics of the embodiments disclosed in this document.

Therefore, the embodiments disclosed in this document are not intended to limit the technical ideas disclosed in this document, but rather to explain the embodiments, and the scope of the technical ideas disclosed in this document is not limited by these embodiments. The scope of protection of the technical ideas disclosed in this document shall be interpreted in accordance with the claims below, and all technical ideas within the equivalent scope shall be interpreted as being included within the scope of rights of this document.

## Claims

1. A battery management apparatus comprising:
an information acquisition unit configured to acquires a voltage of each of a plurality of battery cells; and
a controller configured to:
calculates a resistance of each of the plurality of battery cells corresponding to a SOC class including at least one SOC based on the voltage of each of the plurality of battery cells when the plurality of battery cells are charged based on a preset charging protocol and
diagnoses each of the plurality of battery cells based on the resistance of each of the plurality of battery cells corresponding to the SOC class.

2. The apparatus of claim 1, wherein the controller is configured to:
calculates a first average resistance of each of the plurality of battery cells which corresponds to an average of resistances corresponding to the SOC class for each of the plurality of battery cells,
calculates a second average resistance corresponding to an average of the first average resistance of each of the plurality of battery cells, and
diagnoses each of the plurality of battery cells based on the first average resistance and the second average resistance of each of the plurality of battery cells.

3. The apparatus of claim 2, wherein the controller is configured to:
calculates a probability distribution of the first average resistance of each of the plurality of battery cells based on the first average resistance and the second average resistance of each of the plurality of battery cells, and
diagnoses each of the plurality of battery cells based on the probability distribution.

4. The apparatus of claim 2, wherein the controller is configured to:
calculates a standard deviation of the first average resistance of each of the plurality of battery cells based on the second average resistance, and
diagnoses that lithium precipitation has occurred in a battery cell having the first average resistance that differs from the second average resistance by a set deviation or more.

5. The apparatus of claim 1, wherein the charging protocol is configured to repeat a charging method of charging as much as a first SOC at a first C-rate and resting for a first time.

6. The apparatus of claim 5, wherein the controller is configured to calculates the resistance of each of the plurality of battery cells while charging the plurality of battery cells at the first C-rate.

7. The apparatus of claim 6, wherein the controller is configured to:
calculates an amount of change in voltage of each of the plurality of battery cells for a second time when charging the plurality of battery cells at the first C-rate, and
calculates the resistance of each of the plurality of battery cells by dividing the change in voltage of each of the plurality of battery cells by a charging current.

8. The apparatus of claim 1, wherein the controller is configured to repeat a charging method of charging as much as a first SOC at a first C-rate and charging for a time set at a second C-rate, and
the second C-rate is smaller than the first C-rate.

9. The apparatus of claim 8, wherein the controller is configured to calculates the resistance of each of the plurality of battery cells while charging the plurality of battery cells at the first C-rate.

10. An operating method of a battery management apparatus, the method comprising:
acquiring a voltage of each of a plurality of battery cells;
calculating a resistance of each of the plurality of battery cells corresponding to a SOC class including at least one SOC based on the voltage of each of the plurality of battery cells when the plurality of battery cells are charged based on a preset charging protocol; and
diagnosing each of the plurality of battery cells based on the resistance of each of the plurality of battery cells corresponding to the SOC class.

11. The method of claim 10, wherein the diagnosing of each of the plurality of battery cells based on the resistance of each of the plurality of battery cells corresponding to the SOC class comprises:
calculating a first average resistance of each of the plurality of battery cells which corresponds to an average of resistances corresponding to the SOC class for each of the plurality of battery cells, and
calculating a second average resistance corresponding to an average of the first average resistance of each of the plurality of battery cells.

12. The method of claim 11, wherein the diagnosing of each of the plurality of battery cells based on the resistance of each of the plurality of battery cells corresponding to the SOC class further comprises:
calculating a probability distribution of the first average resistance of each of the plurality of battery cells based on the first average resistance and the second average resistance of each of the plurality of battery cells, and
diagnosing each of the plurality of battery cells based on the probability distribution.

13. The method of claim 11, wherein the diagnosing of each of the plurality of battery cells based on the resistance of each of the plurality of battery cells corresponding to the SOC class further comprises:
calculating a standard deviation of the first average resistance of each of the plurality of battery cells based on the second average resistance, and
diagnosing that lithium precipitation has occurred in a battery cell having the first average resistance that differs from the second average resistance by a set deviation or more.

14. The method of claim 10, wherein the charging protocol is configured to repeat a charging method of charging as much as a first SOC at a first C-rate and resting for a first time.

15. The method of claim 14, wherein the calculating of a resistance of each of the plurality of battery cells corresponding to a SOC class including at least one SOC based on the voltage of each of the plurality of battery cells when the plurality of battery cells are charged based on a preset charging protocol comprises:
calculating the resistance of each of the plurality of battery cells, while charging the plurality of battery cells at the first C-rate.

16. The method of claim 15, wherein the calculating of a resistance of each of the plurality of battery cells corresponding to a SOC class including at least one SOC based on the voltage of each of the plurality of battery cells when the plurality of battery cells are charged based on a preset charging protocol comprises:
calculating an amount of change in voltage of each of the plurality of battery cells for a second time when charging the plurality of battery cells at the first C-rate, and
calculating the resistance of each of the plurality of battery cells by dividing the change in voltage of each of the plurality of battery cells by a charging current.

17. The method of claim 10, wherein the charging protocol is configured to repeat a charging method of charging as much as a first SOC at a first C-rate and charging for a time set at a second C-rate, and
the second C-rate is smaller than the first C-rate.

18. The method of claim 17, wherein the calculating of a resistance of each of the plurality of battery cells corresponding to a SOC class including at least one SOC based on the voltage of each of the plurality of battery cells when the plurality of battery cells are charged based on a preset charging protocol comprises:
calculating the resistance of each of the plurality of battery cells is calculated while charging the plurality of battery cells at the first C-rate.
